Europäisches Patentamt

European Patent Office

Office européen des brevets

(19)

(11) EP 0 595 175 B1

(12) **EUROPÄISCHE PATENTSCHRIFT**

(45) Veröffentlichungstag und Bekanntmachung des Hinweises auf die Patenterteilung:
**14.02.1996 Patentblatt 1996/07**

(51) Int Cl.6: **C23C 16/44**

(21) Anmeldenummer: **93116937.9**

(22) Anmeldetag: **20.10.1993**

(54) **Vorrichtung zur Versorgung von CVD-Beschichtungseinrichtungen**

Device for the supply of CVD-deposition-equipment

Dispositif pour l'approvisionnement d'appareillages destinés au dépôt chimique en phase vapeur

(84) Benannte Vertragsstaaten:
**BE CH DE FR GB IT LI NL**

(30) Priorität: **28.10.1992 DE 4236324**

(43) Veröffentlichungstag der Anmeldung:
**04.05.1994 Patentblatt 1994/18**

(73) Patentinhaber:
- **SCHOTT GLASWERKE**
  **D-55014 Mainz (DE)**
  Benannte Vertragsstaaten:
  **BE CH DE FR GB IT LI NL**
- **CARL-ZEISS-STIFTUNG**
  **trading as SCHOTT GLASWERKE**
  **D-55014 Mainz (DE)**
  Benannte Vertragsstaaten:
  **GB**

(72) Erfinder:
- **Bittner, Hans-Joachim**
  **D-55218 Ingelheim (DE)**
- **Klein, Hans-Jürgen**
  **D-37581 Bad Gandersheim (DE)**
- **Küpper, Thomas**
  **D-37581 Bad Gandersheim (DE)**
- **Mörsen, Ewald**
  **D-64546 Mörfelden (DE)**

(74) Vertreter: **Dr. Fuchs, Dr. Luderschmidt Dr. Mehler, Dipl.-Ing Weiss Patentanwälte**
**D-65036 Wiesbaden (DE)**

(56) Entgegenhaltungen:
**EP-A- 0 018 068**

- **PATENT ABSTRACTS OF JAPAN, unexamined applications, C Sektion, Band 14, Nr. 578, 21. Dezember 1990 THE PATENT OFFICE JAPANESE GOVERNMENT Seite 7 C 791**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft eine Vorrichtung zur Versorgung von mindestens einer CVD-Beschichtungseinrichtung mit Beschichtungsgas mit mindestens einem Vorratsbehälter für das Beschichtungsmaterial und einem Rohrleitungssystem zwischen Vorratsbehälter und Beschichtungseinrichtung, wobei im Rohrleitungssystem Massenflußregler und/oder Ventile angeordnet sind.

Für die gleichzeitige Beschichtung mehrerer Substrate mittels eines CVD-Verfahrens ist es bekannt, mehrere Beschichtungsstationen vorzusehen, die mit den für die Beschichtung geeigneten gasförmigen Beschichtungsmaterialien versorgt werden. Für jede Gasmischung ist eine allen Beschichtungsstationen gemeinsame Gasquelle vorgesehen.

Kaltlichtspiegel können beispielsweise hergestellt werden, indem eine Wechselfolge von zwei Schichten mit unterschiedlichen Zusammensetzungen (insgesamt 20 bis 40 Schichten) und unterschiedlichen Schichtdikken aufgebracht wird. Hierbei kommt es darauf an, daß ein schneller Wechsel von einer Gasmischung auf die andere möglich ist, damit die Gesamtzeit für die vollständige Beschichtung der Substrate aus wirtschaftlichen Gründen möglichst kurz gehalten werden kann. Außerdem soll wegen der hohen Kosten der Schichtbildnergase eine wirtschaftliche Verwendung angestrebt werden, d.h. die Gase sollten möglicht vollständig im Schichtmaterial umgesetzt werden, ohne daß ein Teil ungenutzt abfließt und entsorgt werden muß.

Aus JP-A-02-290977 ist ein Gaserzeuger bekannt, der nicht auf dem Prinzip der Direktverdampfung beruht, sondern auf dem Trägergasprinzip. Durch zwei Zuleitungen werden verschiedene Trägergase zwei Sublimationsbädern zugeführt, in denen sich weitere Substanzen befinden. Nach erfolgter Sublimation gelangen die Gase in eine Mischkammer und von dort zur Reaktionskammer, wo die Beschichtung durchgeführt wird. Hierbei erfolgt eine genaue Temperatursteuerung.

Die EP 0 018 068 beschreibt eine Anlage zur geregelten Zufuhr von Dämpfen von Flüssigkeiten mit geringem Dampfdruck zu einer Anlage zur Herstellung von Vorformen für Lichtwellenleiter nach einem CVD-Verfahren. Die Herstelldauer einer Vorform liegt im Stundenbereich, so daß Änderungen der Gaszusammensetzung nur langsam erfolgen müssen. Deshalb sind Einstellzeiten der Massenflußregler für die Beschichtungsdauer nicht von Belang. Da das Reaktionsgas nur fließt, wenn damit beschichtet wird, stellt sich das Problem einer wirtschaftlichen Verwendung dieser Gase nicht. Zum Austausch der Vorratsbehälter muß die Verbindungsleitung zur Beschichtungseinrichtung unterbrochen werden, so daß die jeweilige Nutzungsdauer der Anlage durch die Kapazität der Vorratsbehälter beschränkt ist.

Aufgabe der vorliegenden Erfindung ist eine Vorrichtung zur gleichmäßigen Versorgung von CVD-Beschichtungseinrichtungen mit Beschichtungsgasen, die ein schnelles Wechseln der Beschichtungsgase bei wirtschaftlichem Einsatz ohne Gasverluste erlaubt und eine kontinuierliche Versorgung ohne Unterbrechung gewährleistet.

Diese Aufgabe wird mit einer Vorrichtung gemäß Anspruch 1 gelöst.

Diese Vorrichtung enthält einen großvolumigen Zwischenspeicher zwischen dem Vorratsbehälter und der oder den Beschichtungseinrichtung(en). Es entstehen dann höchstens nur kleine Druckunterschiede in den Zuleitungen zu den einzelnen Beschichtungseinrichtungen, die sich schnell ausgleichen. Ein weiterer Vorteil besteht darin, daß das Gas im Zwischenspeicher sofort zur Verfügung steht und somit von der oder den Gasquellen des Vorratsbehälters und deren Bedingungen unabhängig ist. Auch dann, wenn die Gaszuführung vom Vorratsbehälter zum Zwischenspeicher unterbrochen oder gestört sein sollte, kann für eine gewisse Zeit die Beschichtungseinrichtung weiterhin mit Gas versorgt werden, ohne daß der Beschichtungsvorgang unterbrochen werden muß. Insbesondere dann, wenn mindestens zwei Vorratsbehälter vorgesehen sind, ist ein kontinuierlicher Betrieb gewährleistet, weil der Austausch des jeweils leeren Vorratsbehälters ohne Zeitdruck erfolgen kann, da der andere (gefüllte) Vorratsbehälter die Versorgung des Zwischenspeichers aufrechterhält.

Das Volumen des Zwischenspeichers wird so groß gewählt, daß bei der Gasentnahme nur eine vorgegebene maximale Druckänderung im Zwischenspeicher auftritt. Das Volumen $V_z$ des Zwischenspeichers liegt im Bereich von 0,1 V bis 10 V, wobei $V = M/(p_z \cdot (\Delta p/p)_z^\bullet)$ bedeutet. Mit M wird der Gesamtmassenfluß des Beschichtungsgases in mbar $\cdot$ l/s bezeichnet und $(\Delta p/p)_z^\bullet$ ist die vorgegebene relative Druckänderung pro Sekunde im Zwischenspeicher. $p_z$ bezeichnet den Druck im Zwischenspeicher im mbar, wobei $p_z$ größer ist als der Prozeßdruck in der Beschichtungseinrichtung.

In einem Beispiel soll die Anforderung an das Volumen des Zwischenspeichers verdeutlicht werden. Es wurde ein Plasmaimpuls-CVD-Verfahren zur Beschichtung von Kalotten mit einer $TiO_2$-Schicht eingesetzt. Die Beschichtungsparameter waren wie folgt:
Periodendauer: 15 msec
Kalottenvolumen: 50 ml
Prozeßdruck: 1 mbar
$TiCl_4$-Druck im Zwischenspeicher: 50 mbar
Temperatur im Zwischenspeicher: 50°C
Zusammensetzung des Beschichtungsgases: 2% $TiCl_4$ und 98% $O_2$ Zahl der gleichzeitig zu beschichtenden Kalotten: 52

In diesem Beispiel liegt der $TiCl_4$-Massenflußbedarf bei M = 3,5 mbar $\cdot$ l/sec. Dies entspricht bei 50 mbar einem Volumenstrom von 70 ml/sec. Soll sich der Druck in dem Zwischenspeicher durch die Entnahme dieses Gasvolumens um höchstens 0,5% vermindern (ent-

spricht $(\Delta p/p)_z^\bullet = 0{,}005/s)$, muß der Zwischenspeicher ein Volumen von 14 l aufweisen. Da unter den vorliegenden Bedingungen die Gasströmung laminar ist, hängt der durch die Rohrleitungen fließende Massenfluß vom Vordruck quadratisch ab. Der Massenfluß ändert sich somit höchstens um 1%/sec.

Um die Gasentnahme durch nachströmendes Gas aus dem Vorratsbehälter möglichst schnell auffüllen zu können, sollten Regelventile und/oder Massenflußregler, die zwischen Vorratsbehälter und Zwischenspeicher angeordnet sind, eine Einstellzeit <1 sec aufweisen.

Der Zwischenspeicher weist einen Druckmesser und einen Temperaturfühler auf, wovon der Temperaturfühler an eine Regeleinrichtung angeschlossen ist. Durch eine mit der ersten Regeleinrichtung verbundene Temperiereinrichtung wird die Temperatur auf einem vorgegebenen konstanten Wert gehalten. Die Temperatur liegt vorzugsweise zwischen 30 und 200°C. Der Druckmesser ist an eine weitere Regeleinrichtung angeschlossen, die den Druck des im Zwischenspeicher enthaltenen Gases zwischen 20 und 1000 mbar hält. Der Zwischenspeicher kann das Schichtbildnermaterial im gasförmigen Zustand oder auch im flüssigen und gasförmigen Zustand im thermischen Gleichgewicht enthalten.

Der Zwischenspeicher ist an mindestens ein Vorratsgefäß angeschlossen, in dem das Schichtbildnergas erzeugt wird. Beispielsweise bei der Herstellung von Kaltlichtspiegeln werden $TiO_2$-und $SiO_2$-Schichten abwechselnd mittels eines Plasma-CVD-Verfahrens aufgebracht. Hierfür können Mischungen aus Sauerstoff und dem Schichtbildner Hexamethyldisiloxan (HMDSO) einerseits und Sauerstoff und dem Schichtbildnermaterial Titantetrachlorid ($TiCl_4$) andererseits als Beschichtungsgase eingesetzt werden. HMDSO und $TiCl_4$ sind bei Raumtemperatur flüssig und haben einen Dampfdruck von etwa 43 bzw. 13 mbar.

Für jedes Schichtbildnermaterial sind eigene Vorratsgefäße und Zwischenspeicher vorgesehen.

Vorzugsweise sind zwei gleiche Vorratsbehälter an einen Zwischenspeicher angeschlossen. Aus dem ersten Vorratsbehälter wird bei Bedarf erwärmtes Gas an den Zwischenspeicher abgegeben, während im zweiten Gefäß der Nachfüllvorgang, das Entgasen der Flüssigkeiten und das Aufheizen abläuft. Die Temperatur der Flüssigkeit wird beispielsweise durch Beheizung der Vorratsbehälter auf einen solchen Wert eingestellt, daß der Dampfdruck der Flüssigkeiten als Vordruck für handelsübliche Massenflußregler ausreichend hoch ist, die zwischen dem Vorratsbehälter und dem Zwischenspeicher angeordnet sind. Als ausreichend kann ein Druck von 50 bis 100 mbar angesehen werden. Dies entspricht für $TiCl_4$ und HMDSO einer Temperatur von 50 bis 60 bzw. 30 bis 45°C.

Die Vorratsbehälter enthalten vorzugsweise Temperaturfühler für die Thermostatisierung und außerdem Füllstandssensoren, die an eine Regeleinrichtung angeschlossen sind. Diese schaltet die Ventile der Vorratsbehälter, so daß eine konstante Gaserzeugung gewährleistet ist. Ist der Füllstand unter einen Grenzwert abgefallen, erfolgt - für den Dampfstrom praktisch unterbrechungsfrei - über eine Ventilanordnung das Umschalten auf den gefüllten und betriebsbereiten Reservevorratsbehälter.

Die Befüllung der Behälter kann entweder vor Ort erfolgen oder es können anderswo gefüllte Vorratsbehälter angeschlossen werden. Durch eine geeignete Gasspülung wird dabei eine Verschmutzung kritischer Oberflächen ausgeschlossen.

Gemäß einer anderen Ausführungsform ist der Druckmesser mit einem in der Rohrleitung zwischen Vorratsbehälter und Zwischenspeicher angeordnetem Regelventil oder Massenflußregler über eine Regeleinrichtung elektrisch verbunden. Damit wird eine Anordnung zur Konstanthaltung des Druckes im Zwischenspeicher geschaffen. Wenn dem Zwischenspeicher Schichtbildnergas entnommen wird, sinkt der Druck unter den vorgegebenen Grenzwert. Dann wird über das Regelventil oder den Massenflußregler so lange Schichtbildnergas aus den Vorratsbehälter nachgeliefert, bis der Solldruck im Zwischenspeicher erreicht ist. Diese Ausführungsform bietet den Vorteil, daß kein Schichtbildnergas in den Beschichtungspausen verworfen werden muß.

Wenn der Zwischenspeicher gemäß einer weiteren Ausführungsform das flüssige Schichtbildnermaterial und das entsprechende Gas im thermischen Gleichgewicht enthält, wobei die Temperatur auf einen Sollwert geregelt ist, weist der Zwischenspeicher einen Füllstandmesser auf, der mit einem in der Rohrleitung zwischen Vorratsbehälter und Zwischenspeicher angeordneten Ventil oder Massenflußregler über eine Regeleinrichtung elektrisch verbunden ist. Der Füllstandmesser besitzt Grenzwertgeber, so daß der Füllstand zwischen zwei Niveaus geregelt werden kann. Wenn der Füllstand unter einen vorgegebenen Grenzwert abfällt, wird über das Ventil oder den Massenflußregler Beschichtungsmaterial in flüssiger Form vom Vorratsbehälter nachgefüllt. Eine Druckregelung wie bei der zuvor beschriebenen Ausführungsform ist dann nicht erforderlich.

Aus Gründen der Prozeßstabilität kann es erforderlich sein, daß die Gase auch dann aus den jeweiligen Vorratsbehältern ausströmen, wenn sie gar nicht zur Beschichtung benötigt werden, wie z.B. in den Beschichtungspausen. Um die meist kostspieligen Schichtbildnermaterialien zurückgewinnen zu können, ist der Zwischenspeicher an eine Gasrückgewinnungsstation angeschlossen. Vorzugsweise ist in der Rohrleitung zwischen der Gasrückgewinnungsstation und dem Zwischenspeicher ein Ventil angeordnet, das mit dem Druckmesser des Zwischenspeichers über eine Regeleinrichtung elektrisch verbunden ist. Das ständig aus dem oder den Vorratsbehältern nachströmende Gas würde in den Beschichtungspausen zu einem unerwünschten Druckanstieg im Zwischenspeicher führen. Dieser Druckanstieg wird vom Druckmesser registriert, der über die Regeleinrichtung das Ventil zwischen der Gasrückgewinnungsstation und dem Zwischenspeicher öffnet, so daß in den Beschichtungspausen das überschüssige Gas in die Gasrückgewinnungsstation strömen kann.

Das Rückgewinnungsgefäß der Gasrückgewinnungsstation befindet sich auf einer niedrigeren Temperatur als der Zwischenspeicher und wird auf dieser gehalten, so daß das überflüssige Gut dort kondensiert und das Rückgewinnungsgefäß als Kryopumpe wirkt und somit zum Abpumpen keine zusätzliche Pumpe benötigt wird. Die kondensierte Flüssigkeit ist hochrein und kann zur Beschichtung wiederverwendet werden.

Gemäß einer weiteren Ausführungsform ist die zwischen Vorratsbehälter und Zwischenspeicher angeordnete Rohrleitung über ein Ventil an die Gasrückgewinnungsstation angeschlossen. In dieser Ausführungsform ist der Druckmesser des Zwischenspeichers und das Ventil in der zur Gasrückgewinnungsstation führenden Rohrleitung an die Regeleinrichtung angeschlossen. Das Gas strömt ebenfalls ununterbrochen aus dem Vorratsbehälter aus, und führt in den Beschichtungspausen zu einem Druckanstieg im Zwischenspeicher, der vom Druckmesser detektiert wird. In diesem Fall wird über die Regeleinrichtung das Ventil in der zur Gasrückgewinnungsstation führenden Rohrleitung geöffnet, so daß das überschüssige Gas ohne Umweg über den Zwischenspeicher in die Gasrückgewinnungsstation strömen kann.

Zusätzlich zu den zuvor beschriebenen Ausführungsformen kann der Druckmesser und der Temperaturfühler elektrisch mit einer Steuereinrichtung verbunden sein, die an die Beschichtungseinrichtung angeschlossen ist und die Beschichtungsdauer oder den Massenfluß der Beschichtungsgase steuert. Dies bietet den Vorteil, daß der aktuelle, vom Sollwert möglicherweise abweichende Druck des Schichtbildnergases im Zwischenspeicher als Parameter für die Beschichtungsdauer oder den Massenfluß der Beschichtungsgase genommen werden kann, so daß auch kleinste Änderungen des Drucks, über eine entsprechende Regelung von Beschichtungsdauer oder Massenfluß berücksichtigt werden können. Auf diese Weise wird immer die Sollschichtdicke auf die zu beschichtenden Substrate aufgebracht.

Beispielhafte Ausführungsformen werden nachfolgend anhand der Zeichnungen näher erläutert.

Es zeigen:

Figur 1    die schematische Darstellung einer Versorgungsvorrichtung gemäß einer ersten Ausführungsform,

Figur 2    die schematische Darstellung einer Versorgungsvorrichtung gemäß einer weiteren Ausführungsform,

Figur 3    die schematische Darstellung einer Ausführungsform mit Gasrückgewinnung und

Figur 4    die schematische Darstellung einer Vorrichtung mit Gasrückgewinnung gemäß einer weiteren Ausführungsform und

Figur 5    eine schematische Darstellung der Vorrichtung, in der Gas und Flüssigkeit im thermischen Gleichgewicht sind.

In den nachfolgenden Figuren sind Vorrichtungen zum Entgasen der Flüssigkeiten in den Vorratsbehältern nicht dargestellt.

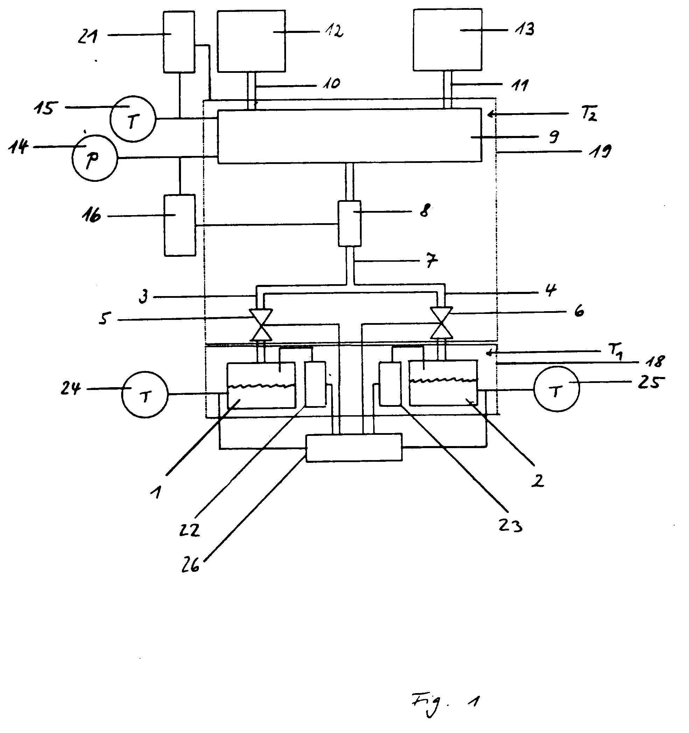

In der Figur 1 ist eine Vorrichtung mit einem Zwischenspeicher 9 schematisch dargestellt, an den zwei Vorratsbehälter 1 und 2 angeschlossen sind. Diese Vorratsbehälter 1 und 2 besitzen Grenzwertgeber 22, 23, die an eine gemeinsame Regeleinrichtung 26 angeschlossen sind. Weiterhin sind die Vorratsbehälter 1 und 2 mit Temperaturfühlern 24 und 25 ausgestattet, die ebenfalls an die Regeleinrichtung 26 angeschlossen sind.

Um einen kontinuierlichen Gasfluß aus den Vorratsbehältern 1 oder 2 aufrechtzuerhalten, ist es erforderlich, daß die Behälter auf einer vorgegebenen Temperatur $T_1$ gehalten werden. Dies geschieht mit üblicher Technik.

Die beiden Vorratsbehälter 1 und 2 sind über Rohrleitungen 3 und 4 mit einer Hauptleitung 7 verbunden, die in den Zwischenspeicher 9 mündet. In den Rohrleitungen 3 und 4 sind Ventile 5 und 6 vorgesehen, damit bei einem Austausch eines leeren Vorratsbehälters 1, 2 die Verbindung zum Zwischenspeicher 9 unterbrochen werden kann. In der Hauptleitung 7 ist ein Massenflußregler 8 angeordnet, der auch durch ein Regelventil ersetzt sein kann. Dieser Massenflußregler stellt sicher, daß die aus dem Vorratsbehälter 1 oder 2 nachströmende Gasmenge auf einem gewünschten Wert gehalten wird.

Der Zwischenspeicher 9 ist mit einem Druckmesser 14 und einem Temperaturfühler 15 ausgestattet. Letzterer ist an eine Regeleinrichtung 21 angeschlossen, die mit einer Temperiereinrichtung 19 für den Zwischenspeicher 9 verbunden ist, so daß dieser auf eine gewünschte Temperatur $T_2 > T_1$ geregelt werden kann.

Vom Zwischenspeicher 9 führen Rohrleitungen 10, 11 zu Beschichtungseinrichtungen 12 und 13. In der hier gezeigten Darstellung sind lediglich zwei Beschichtungseinrichtungen dargestellt, es können auch mehr als zwei Beschichtungseinrichtungen an einem Zwischenspeicher 9 angeschlossen sein. Jede Beschichtungseinrichtung 12, 13 kann mehrere Beschichtungsstationen aufweisen, wobei die Aufteilung der Gasmassenflüsse durch ein symmetrisches, gegebenenfalls mit Mitteln zur Einstellung des Strömungswiderstandes versehenen Rohrsystem erfolgt, so daß der Strömungswiderstand zwischen Zwischenspeicher und jeder Beschichtungsstation und damit die Aufteilung des Gases möglichst gleichmäßig ist. Sollen durch die Anordnung gleichzeitig (ausnahmsweise) unterschiedlich große Beschichtungsstationen versorgt werden, dann müssen lediglich die Strömungswiderstände der zu diesen führenden Rohrleitungen angepaßt werden. Die symmetrischen Rohrsysteme sowie zwischen dem Zwischenspeicher 9 und den Beschichtungsstationen angeordnete Ventile sind in der Figur 1 nicht dargestellt. An die Beschichtungseinrichtungen 12, 13 sind weitere Zwischenspeicher (nicht dargestellt) mit den dazugehörigen Einrichtungen für andere Schichtbildnergase angeschlossen.

Wie in der Figur 1 dargestellt ist, ist der Druckmesser 14 mit einer Regeleinrichtung 16 verbunden, die mit dem Massenflußregler 8 in Verbindung steht. Wenn zur Beschichtung das Gas aus dem Zwischenspeicher 9 in die Beschichtungseinrichtungen 12 und 13 strömt, fällt der Druck im Zwischenspeicher 9 unter einen vorgegebenen Sollwert, der vom Druckmesser 14 gemessen wird. Durch ein entsprechendes Signal der Regeleinrichtung 16 wird dann der Massenflußregler 8 oder das Ventil 8 in der Hauptleitung 7 geöffnet, so daß Gas aus dem jeweils aktiven Vorratsbehälter 1 oder 2 nachfließen kann bis der vorgegebene Sollwert wieder erreicht ist.

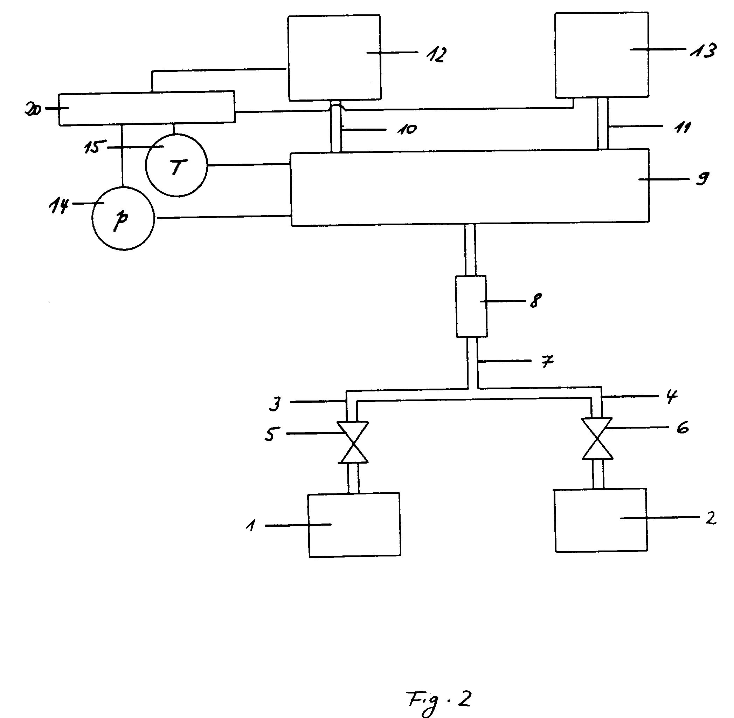

In der Figur 2 ist eine weitere Ausführungsform dargestellt. Der Druckmesser 14 und der Temperaturfühler 15 sind an eine Steuereinrichtung 20 angeschlossen, die elektrisch mit den Beschichtungseinrichtungen 12 und 13 verbunden ist. Diese Steuereinrichtung kann auch in Verbindung mit den in Figur 1, Figur 3, 4 oder 5 gezeigten Ausführungsformen eingesetzt werden. Die in Figur 1, 3, 4 oder 5 gezeigten Komponenten der Vorrichtung wurden daher in der Figur 2 weggelassen. Wenn im Zwischenspeicher 9 Temperatur- und Druckschwankungen auftreten sollten, die die Beschichtung in den Beschichtungseinrichtungen 12 und 13 negativ beeinflussen könnten, so wird die Beschichtungsdauer und der Massenfluß in den Beschichtungseinrichtungen 12 und 13 durch die Steuereinrichtung 20 entsprechend gesteuert, so daß auch kleinste Schwankungen kompensiert werden können. Mit dieser Einrichtung ist einerseits eine Feinabstimmung der Schichtdicke möglich, andererseits ist eine weitere Sicherheitsreserve gegen Störfälle gegeben.

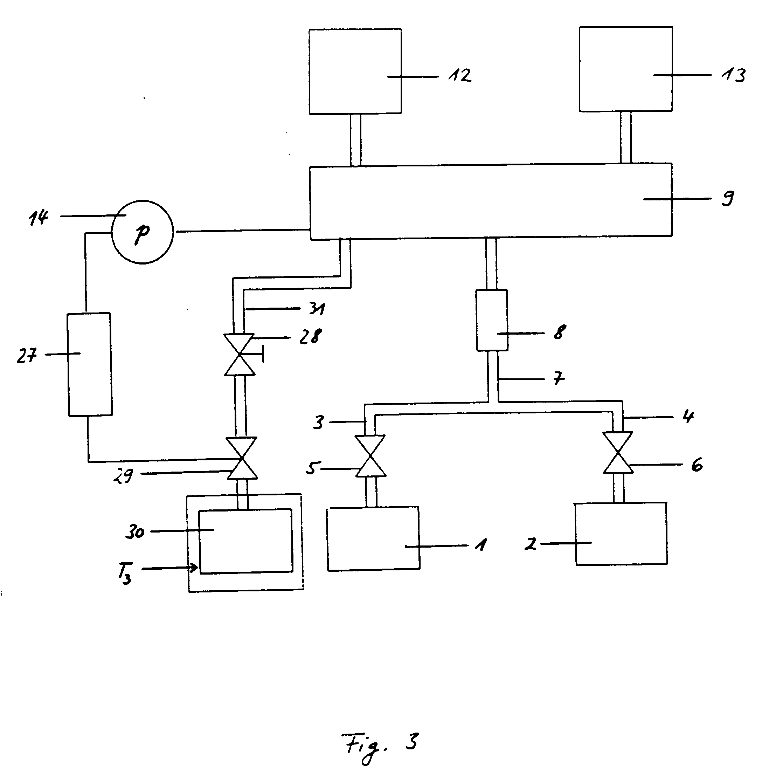

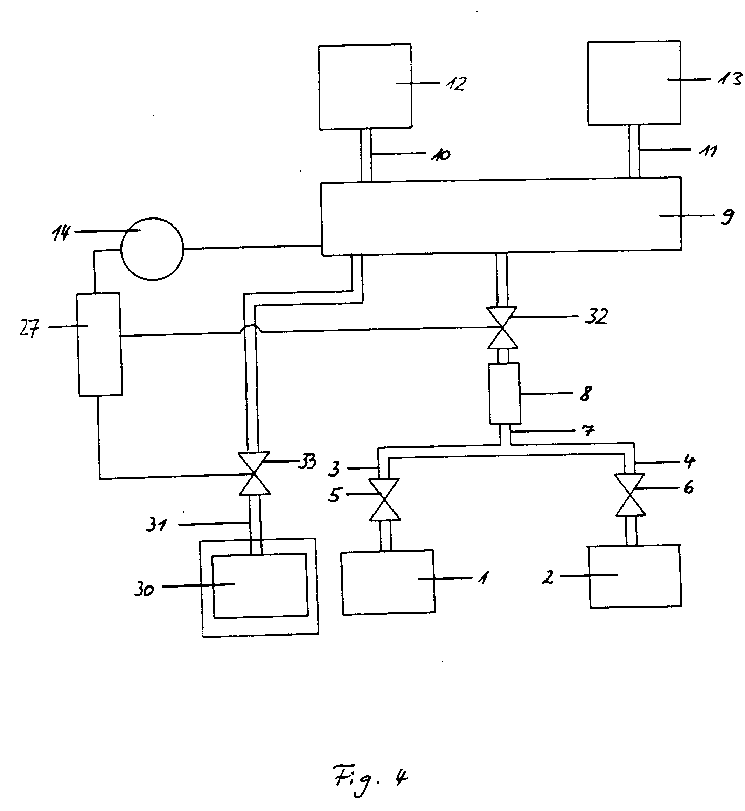

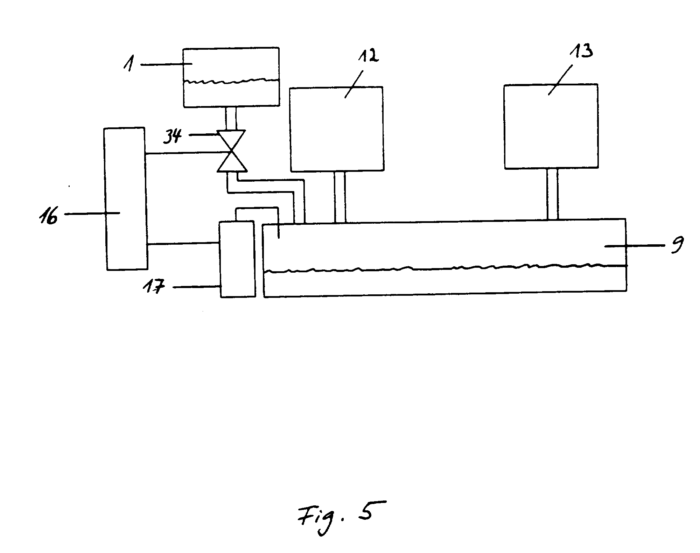

In der Figur 3 ist eine Anordnung mit einer Gasrückgewinnungsstation 30 dargestellt. Aus Gründen der Übersichtlichkeit, wurden einige in Figur 1 dargestellte Komponenten hier weggelassen. Der Zwischenspeicher 9 ist über eine Rohrleitung 31, in der eine Drossel 28 und ein Ventil 29 angeordnet sind, mit der Gasrückgewinnungsstation 30 verbunden, die sich auf einer gegenüber der Temperatur $T_2$ des Zwischenspeichers niedrigeren Temperatur $T_3$ befindet. Der Druckmesser 14 ist über eine Regeleinrichtung 27 mit dem Ventil 29 verbunden. Wenn der Druck in einer Beschichtungspause im Zwischenspeicher 9 über einen vorgegebenen Sollwert ansteigt, so wird dies vom Druckmesser 14 gemessen, woraufhin das Ventil 29 geöffnet wird, so daß überschüssiges Schichtbildnergas in die Gasrückgewinnungsstation 30 abfließen und kondensieren kann. Die Drossel 28 dient dazu, daß ein stoßfreier Abfluß aus dem Zwischenspeicher 9 gewährleistet ist.

In der Figur 4 ist eine gegenüber der in Figur 3 geänderte Anordnung bezüglich der Gasrückgewinnungsstation 30 schematisch dargestellt. Die zur Gasrückgewinnungsstation 30 führende Rohrleitung 31 mündet in die Hauptleitung 7 und zwar zwischen dem Massenflußregler 8 und einem Ventil 32. In der Rohrleitung 31 ist ein Ventil 33 angeordnet, das über die Regeleinrichtung 27 mit dem Druckmesser 14 verbunden ist. Wenn der Druck im Zwischenspeicher 9 in einer Beschichtungspause über den vorgegebenen Sollwert ansteigt, wird über die Regeleinrichtung 27 das Ventil 32 geschlossen und das Ventil 33 geöffnet, so daß das aus dem Vorratsbehälter 1 oder 2 kontinuierlich nachströmende Gas in die Gasrückgewinnungsstation 30 umgelenkt wird.

Wenn der Zwischenspeicher 9 das Schichtbildnermaterial sowohl in flüssiger als auch gasförmiger Form enthält (Figur 5), ist der Zwischenspeicher 9 mit einem Füllstandmesser 17 ausgestattet, der als Alternative zum Druckmesser mit der Steuereinrichtung 16 verbunden ist. Wenn der Flüssigkeitsstand im Zwischenspeicher 9 unter einen bestimmten Wert abfällt, so wird dies vom Füllstandmesser 17 detektiert, woraufhin ein Ventil 34 geöffnet wird, so daß flüssiges Schichtbildnermaterial aus dem Vorratsbehälter 1 in den Zwischenspeicher 9 nachströmen kann.

Bezugzeichen:

| | |
|---|---|
| 1 | Vorratsbehälter |
| 2 | Vorratsbehälter |
| 3 | Rohrleitung |
| 4 | Rohrleitung |
| 5 | Ventil |
| 6 | Ventil |
| 7 | Hauptleitung |
| 8 | Massenflußregler |
| 9 | Zwischenspeicher |
| 10 | Rohrleitung |
| 11 | Rohrleitung |
| 12 | Beschichtungseinrichtung |
| 13 | Beschichtungseinrichtung |
| 14 | Druckmesser |
| 15 | Temperaturfühler |
| 16 | Regeleinrichtung |
| 17 | Füllstandsmesser |
| 18 | Heizeinrichtung |
| 19 | Heizeinrichtung |
| 20 | Steuereinrichtung |
| 21 | Regeleinrichtung |
| 22 | Füllstandsensor |
| 23 | Füllstandsensor |
| 24 | Temperaturfühler |
| 25 | Temperaturfühler |
| 26 | Regeleinrichtung |
| 27 | Regeleinrichtung |

28  Drossel
29  Ventil
30  Gasrückgewinnungsstation
31  Rohrleitung
32  Ventil
33  Ventil
34  Ventil

**Patentansprüche**

1.  Vorrichtung zur Versorgung von mindestens einer CVD-Beschichtungseinrichtung mit Beschichtungsgas mit mindestens einem Vorratsbehälter für das Beschichtungsmaterial und einem Rohrleitungssystem zwischen Vorratsbehälter und Beschichtungseinrichtung, wobei im Rohrleitungssystem Massenflußregler und/oder Ventile sowie ein Zwischenbehälter angeordnet sind, der zur Aufnahme des gasförmigen Beschichtungsmaterials dient, dadurch gekennzeichnet,

    daß der Zwischenbehälter ein Zwischenspeicher (9) ist, dessen Volumen an eine vorgegebene maximale Druckänderung im Zwischenspeicher (9) bei Entnahme der für eine Beschichtung benötigten Gasmasse angepaßt ist, wobei der Zwischenspeicher (9) ein Volumen $V_z$ aufweist mit $0,1V < V_z < 10V$, wobei

    $$V = M/(P_z \cdot (\Delta p/p)^{\bullet}_z)$$

    M = Gesamtmassenfluß des Beschichtungsgases in mbar . l/sec

    $(\Delta p/p)^{\bullet}_z$ = vorgegebene relative Druckänderung pro sec im Zwischenspeicher

    $p_z$ = Druck im Zwischenspeicher in mbar mit $p_z$ > Prozeßdruck in der Beschichtungseinrichtung.

2.  Vorrichtung nach Anspruch 1, dadurch gekennzeichnet, daß der Zwischenspeicher (9) einen Druckmesser (14) und einen Temperaturfühler (15) aufweist, wobei der Temperaturfühler (15) an eine Regeleinrichtung (21) angeschlossen ist.

3.  Vorrichtung nach Anspruch 2, dadurch gekennzeichnet, daß der Druckmesser (14) mit einem in der Rohrleitung (7) zwischen Vorratsbehälter (1, 2) und Zwischenspeicher (9) angeordneten Regelventil oder Massenflußregler (8) über eine Regeleinrichtung (16) elektrisch verbunden ist.

4.  Vorrichtung nach einem der Ansprüche 1 bis 3, dadurch gekennzeichnet, daß der Zwischenspeicher (9) einen Füllstandmesser (17) aufweist, der mit einem in der Rohrleitung (7) zwischen Vorratsbehälter (1, 2) und Zwischenspeicher (9) angeordneten Ventil oder Massenflußregler (8) über die Regeleinrichtung (16) elektrisch verbunden ist.

5.  Vorrichtung nach einem der Ansprüche 2 oder 3, dadurch gekennzeichnet, daß der Druckmesser (14) und der Temperaturfühler (15) elektrisch mit einer Steuereinrichtung (20) verbunden ist, die an die Beschichtungseinrichtung (12, 13) angeschlossen ist und die Beschichtungsdauer oder den Massenfluß der Beschichtungsgase steuert.

6.  Vorrichtung nach einem der Ansprüche 1 bis 5, dadurch gekennzeichnet, daß an dem Zwischenspeicher (9) mindestens zwei Vorratsbehälter (1, 2) für ein Beschichtungsmaterial angeschlossen sind.

7.  Vorrichtung nach einem der Ansprüche 1 bis 6, dadurch gekennzeichnet, daß jeder Vorratsbehälter (1, 2) über ein Ventil (5, 6) an eine zum Zwischenspeicher (9) führende Hauptleitung (7) angeschlossen ist, in der der Massenflußregler (8) angeordnet ist.

8.  Vorrichtung nach einem der Ansprüche 1 bis 7, dadurch gekennzeichnet, daß jeder Vorratsbehälter (1, 2) Füllstandssensoren (22, 23) für den Flüssigkeitsstand und Temperaturfühler (24, 25) aufweist, die an eine Regeleinrichtung (26) angeschlossen sind, die eine Temperiereinrichtung (18) steuert.

9.  Vorrichtung nach einem der Ansprüche 1 bis 8, dadurch gekennzeichnet, daß der Zwischenspeicher (9) an eine Gasrückgewinnungsstation (30) angeschlossen ist.

10. Vorrichtung nach Anspruch 9, dadurch gekennzeichnet, daß in der Rohrleitung (31) zwischen Gasrückgewinnungsstation (30) und Zwischenspeicher (9) ein Ventil (29) angeordnet ist, das mit dem Druckmesser (14) des Zwischenspeichers (9) über eine Regeleinrichtung (27) elektrisch verbunden ist.

11. Vorrichtung nach einem der Ansprüche 1 bis 8, dadurch gekennzeichnet, daß die zwischen Vorratsbehälter (1, 2) und Zwischenspeicher (9) angeordnete Rohrleitung (3, 4, 7) über ein Ventil (33) an eine Gasrückgewinnungsstation (30) angeschlossen ist.

**Claims**

1.  A device for the supply of at least one CVD coating device with coating gas, with at least one storage tank for the coating material and a pipeline system between storage tank and coating device, mass flow regulators and/or valves and an intermediate tank being arranged in the pipeline system, which tank serves for receiving the gaseous coating material, characterised in that

the intermediate tank is an intermediate reservoir (9), the volume of which is adapted to a predetermined maximum pressure change in the intermediate reservoir (9) when the gaseous mass needed for a coating is drawn off, the intermediate reservoir (9) having a volume $V_z$ with $0.1V < V_z < 10V$, where

$$V = M/P_z . (\Delta p/p)_z{}^*)$$

M = total mass flow of the coating gas in mbar . l/sec

$(\Delta p/p)_z{}^*$ = predetermined relative pressure change per sec in the intermediate reservoir

$p_z$ = pressure in the intermediate reservoir in mbar with $p_z$ > process pressure in the coating device.

2. A device as claimed in claim 1, characterised in that the intermediate reservoir (9) has a pressure gauge (14) and a temperature sensor (15), the temperature sensor (15) being connected to a control device (21).

3. A device as claimed in claim 2, characterised in that the pressure gauge (14) is electrically connected by way of a control device (16) to a control valve or mass flow regulator (8) arranged in the pipeline (7) between storage tanks (1, 2) and intermediate reservoir (9).

4. A device as claimed in claims 1 to 3, characterised in that the intermediate reservoir (9) has a level gauge (17), which is electrically connected by way of the control device (16) to a valve or mass flow regulator (8) arranged in the pipeline (7) between storage tanks (1, 2) and intermediate reservoir (9).

5. A device as claimed in claims 2 or 3, characterised in that the pressure gauge (14) and the temperature sensor (15) are electrically connected to a control device (20), which is connected to the coating device (12, 13) and which controls the duration of coating or the mass flow of the coating gases.

6. A device as claimed in one of claims 1 to 5 characterised in that at least two storage tanks (1, 2) for a coating material are connected to the intermediate reservoir (9).

7. A device as claimed in claims 1 to 6, characterised in that each storage tank (1, 2) is connected by way of a valve (5, 6) to a main line (7) leading to the intermediate reservoir (9), in which line the mass flow regulator (8) is arranged.

8. A device as claimed in one of claims 1 to 7, characterised in that each storage tank (1, 2) has level sensors (22, 23) for the liquid level and temperature sensors (24, 25), which are connected to a control device (26), which controls a temperature control device (18).

9. A device as claimed in one of claims 1 to 8, characterised in that the intermediate reservoir (9) is connected to a gas recovery station (30).

10. A device as claimed in claim 9, characterised in that a valve (29), which is electrically connected by way of a control device (27) to the pressure gauge (14) of the intermediate reservoir (9), is arranged in the pipeline (31) between gas recovery station (30) and intermediate reservoir (9).

11. A device as claimed in one of claims 1 to 8, characterised in that the pipeline (3, 4, 7) arranged between storage tanks (1, 2) and intermediate reservoir (9) is connected by way of a valve (33) to a gas recovery station (30).

## Revendications

1. Dispositif pour l'approvisionnement en gaz de revêtements d'au moins une installation de revêtement par dépôt chimique en phase vapeur, comprenant au moins un réservoir pour la matière de revêtement et un système de conduites entre le réservoir et l'installation de revêtement, le système de conduites contenant des régulateurs de débit massique et/ou des valves ainsi qu'un accumulateur intermédiaire servant à recevoir la matière de revêtement gazeuse, **caractérisé** par le fait que le récipient intermédiaire est un accumulateur intermédiaire (9) dont le volume est adapté pour permettre une variation de pression maximale prédéterminée dans l'accumulateur intermédiaire (9) lors du prélèvement de la masse de gaz nécessaire pour un revêtement, l'accumulateur intermédiaire (9) présentant un volume $V_z$ tel que $0,1V < V_z < 10V$, où

$$V = M/(P_z . (\Delta p/p)\dot{}_z)$$

M = débit massique total du gaz de revêtement en mbar . l/sec

$(\Delta p/p)\dot{}_z)$ = variation de pression relative prédéterminée par seconde dans l'accumulateur intermédiaire

$p_z$ = pression dans l'accumulateur intermédiaire en mbar, pour $p_z$ > pression de processus dans l'installation de revêtement.

**2.** Dispositif suivant la revendication 1, **caractérisé** par le fait que l'accumulateur intermédiaire (9) présente un manomètre (14) et un détecteur de température (15), le détecteur de température (15) étant raccordé à un dispositif de régulation (21).

**3.** Dispositif suivant la revendication 2, **caractérisé** par le fait que le manomètre (14) est relié électriquement, en passant par un dispositif de régulation (16), à une valve de régulation ou régulateur de débit massique (8) disposé dans la conduite (7) entre le réservoir (1, 2) et l'accumulateur intermédiaire (9).

**4.** Dispositif suivant l'une des revendications 1 à 3, **caractérisé** par le fait que l'accumulateur intermédiaire (9) présente un détecteur de niveau (17) qui est relié électriquement, en passant par le dispositif de régulation (16), à une valve ou régulateur de débit massique (8) disposé dans la conduite (7) entre le réservoir (1, 2) et l'accumulateur intermédiaire (9).

**5.** Dispositif suivant l'une des revendications 2 ou 3, **caractérisé** par le fait que le manomètre (14) et le détecteur de température (15) sont reliés électriquement à un dispositif de commande (20) qui est raccordé à l'installation de revêtement (12, 13) et commande la durée de revêtement ou le débit massique des gaz de revêtement.

**6.** Dispositif suivant l'une des revendications 1 à 5, **caractérisé** par le fait qu'au moins deux réservoirs (1, 2) pour une matière de revêtement sont raccordés à l'accumulateur intermédiaire (9).

**7.** Dispositif suivant l'une des revendications 1 à 6, **caractérisé** par le fait que chaque réservoir (1, 2) est relié par une valve (5, 6) à une conduite principale (7) qui mène à l'accumulateur intermédiaire (9) et dans laquelle est disposé le régulateur de débit massique (8).

**8.** Dispositif suivant l'une des revendications 1 à 7, **caractérisé** par le fait que chaque réservoir (1, 2) présente des détecteurs de niveau (22, 23) pour le niveau de liquide et des détecteurs de température (24, 25) qui sont raccordés à un dispositif de régulation (26) commandant un dispositif de maintien en température (18).

**9.** Dispositif suivant l'une des revendications 1 à 8, **caractérisé** par le fait que l'accumulateur intermédiaire (9) est raccordé à un poste de récupération de gaz (30).

**10.** Dispositif suivant la revendication 9, **caractérisé** par le fait que la conduite (31) entre le poste de récupération de gaz (30) et l'accumulateur intermédiaire (9) renferme une valve (29) qui est reliée électriquement par un dispositif de régulation (27) au manomètre (14) de l'accumulateur intermédiaire (9).

**11.** Dispositif suivant l'une des revendications 1 à 8, **caractérisé** par le fait que la conduite (3, 4, 7) disposée entre le réservoir (1, 2) et l'accumulateur intermédiaire (9) est raccordée par une valve (33) à un poste de récupération de gaz (30).

Fig. 1

Fig. 2

Fig. 3

Fig. 4

Fig. 5